# EUROPEAN PATENT SPECIFICATION

(11) **EP 3 888 994 B1**
(45) Date of publication and mention of the grant of the patent: **28.08.2024**
(21) Application number: 19888268.0
(22) Date of filing: 23.10.2019
(51) Int. Cl.: B61B 13/00, B61B 3/02, H01L 21/677

(54) **TRAVELLING VEHICLE SYSTEM**
SYSTEM MIT FAHRENDEM FAHRZEUG
SYSTÈME DE VÉHICULE EN DÉPLACEMENT

(30) Priority: 28.11.2018 JP 2018222552
(43) Date of publication of application: 06.10.2021
(73) Proprietor: Murata Machinery, Ltd., Kyoto-shi, Kyoto 601-8326 (JP)
(72) Inventor: OGO, Haruki, Inuyama-shi, Aichi 484-8502 (JP); ISHIKAWA, Kazuhiro, Inuyama-shi, Aichi 484-8502 (JP); ITO, Yasuhisa, Ise-shi, Mie 516-0003 (JP); TORAZAWA, Masayoshi, Inuyama-shi, Aichi 484-8502 (JP)
(74) Representative: Stöckeler, Ferdinand
(86) International application number: PCT/JP2019/041503
(87) International publication number: WO 2020/110522

(56) References cited:
- WO-A1-2012/060291
- WO-A1-2018/037762
- WO-A1-2018/037762
- JP-A- 2004 189 209
- JP-A- 2016 175 506
- KR-A- 20150 045 157

## Description

### Technical Field

The present invention relates to a traveling vehicle system.

### Background Art

In semiconductor manufacturing factories or the like, a traveling vehicle system conveying articles such as front opening unified pods (FOUPs) housing semiconductor wafers and reticle pods housing reticles by traveling vehicles is used, for example. As this type of traveling vehicle system, a configuration is known, which includes a track including a first track extending along a first direction, a second track extending along a second direction different from the first direction, and a connection track connecting the first track and the second track to each other, a traveling wheel rolling on the track, a main body placed below the track, a coupler coupling the traveling wheel and the main body to each other, and a direction changer integrally rotating the traveling wheel and the coupler (refer to Patent Literature 1, for example).

### Citation List

### Patent Literature

[Patent Literature 1] International Publication No. WO2018/037762

### Summary of Invention

### Technical Problem

In the traveling vehicle system described in Patent Literature 1, it is necessary that both when the traveling vehicle travels along the first track and when the traveling vehicle travels along the second track, the main body be not positionally deviated in a direction crossing its traveling direction. Consequently, a configuration is considered in which a guide roller or the like is placed in the traveling vehicle, and this guide roller rolls on a guide face provided along the track, whereby the positional deviation of the main body is prevented. However, the traveling vehicle in which the traveling wheel changes directions between traveling along the first track and traveling along the second track as in the above causes a problem in that when a mechanism to change the direction of the guide roller in accordance with the direction change of the traveling wheel is separately provided, the configuration of the traveling vehicle becomes complicated. In addition, an increase in the height dimension of the traveling vehicle by placement of the guide roller causes space efficiency near a ceiling of a building or the like in which the traveling vehicle system is installed to reduce.

An object of the present invention is to provide a traveling vehicle system capable of preventing the positional deviation of a main body of a traveling vehicle by a simple configuration while avoiding the configuration of the traveling vehicle from being complicated.

### Solution to Problem

A traveling vehicle system according to the present invention is a traveling vehicle system, which includes a track including a first track extending along a first direction, a second track extending along a second direction different from the first direction, and a connection track adjacent to the first track in the first direction, adjacent to the second track in the second direction, and placed with a gap with respect to each of the first track and the second track and a ceiling traveling vehicle traveling along the track, the track having a first guide face provided along the first track and a second guide face provided along the second track, and the ceiling traveling vehicle including a traveling wheel rolling on the first track, on the second track, and on the connection track, a main body placed below the track, a coupler coupling a wheel shaft of the traveling wheel and the main body to each other and passing through the gap when the traveling wheel rolls on the connection track, a direction changer switching between a first state in which the traveling wheel rolls on the first track, and a second state in which the traveling wheel rolls on the second track, by turning the coupler about a turning axis with respect to the main body, and a guider provided in the coupler, moving along the first guide face in the first state, and moving along the second guide face in the second state.

The first guide face is a side face of the first track, and the second guide face is a side face of the second track. The guider may be placed at a height between the wheel shaft of the traveling wheel and the main body, and the first guide face and the second guide face may be placed at a height between the wheel shaft of the traveling wheel and the main body. The guider may be a guide roller capable of rolling when coming into contact with the first guide face or the second guide face.

The connection track may have a first connection guide face provided at the same height and in the same direction as the first guide face and a second connection guide face provided at the same height and in the same direction as the second guide face. The connection track may include a continuous face making the first connection guide face and the second connection guide face continuous with each other. The continuous face may be a curved face smoothly connecting the first connection guide face and the second connection guide face to each other. The main body may be rectangular when viewed in an axial direction of the turning axis of the coupler and have the traveling wheel, the coupler, the direction changer, and the guider at each of four corner parts. A spacing between two guiders arranged in a traveling direction of the ceiling traveling vehicle may be different from a spacing between two gaps adjacent to each other in the first direction or in the second direction.

With the traveling vehicle system described above, the guider turns integrally with the coupler, and thus without any separate structure to change the direction of the guider, the direction of the guider can be switched in accordance with the direction change of the traveling wheel. Consequently, the positional deviation of the main body can be prevented by a simple configuration while avoiding the configuration of the traveling vehicle from being complicated.

In the configuration in which the first guide face is a side face of the first track, and the second guide face is a side face of the second track, the side faces of the first track and the second track are used as the first guide face and the second guide face, respectively, whereby part of the tracks can effectively be used as the guide faces of the guider. In the configuration in which the guider is placed at a height between the wheel shaft of the traveling wheel and the main body, and the first guide face and the second guide face are placed at a height between the wheel shaft of the traveling wheel and the main body, the dimension of the traveling vehicle in an up-and-down direction is prevented from increasing, and space efficiency near a ceiling of a building or the like in which the traveling vehicle system is installed can be prevented from reducing. When the guider is a guide roller capable of rolling when coming into contact with the first guide face or the second guide face, frictional resistance when the guider comes into contact with the first guide face or the second guide face can be reduced.

In the configuration in which the connection track has a first connection guide face provided at the same height and in the same direction as the first guide face and a second connection guide face provided at the same height and in the same direction as the second guide face, the guider is in contact with the first connection guide face or the second guide face even in the connection track, whereby the positional deviation of the main body can be prevented. In the configuration in which the connection track includes a continuous face making the first connection guide face and the second connection guide face continuous with each other, when the traveling wheel is turned by the direction changer, the guider is moved along the continuous face, whereby the positional deviation of the main body during the turning of the traveling wheel can be prevented. In the configuration in which the continuous face is a curved face smoothly connecting the first connection guide face and the second connection guide face to each other, smooth movement of the guider on the continuous face can be ensured. In the configuration in which the main body is rectangular when viewed in an axial direction of the turning axis of the coupler and has the traveling wheel, the coupler, the direction changer, and the guider at each of four corner parts, the positional deviation of the main body about a perpendicular axis with respect to the track can be prevented by guiders placed at the four respective corner parts of the main body. In the configuration in which a spacing between two guiders arranged in a traveling direction of the ceiling traveling vehicle is different from a spacing between two gaps adjacent to each other in the first direction or in the second direction, the two guiders arranged in the traveling direction can be prevented from being simultaneously positioned at the gaps.

### Brief Description of the Drawings

Fig. 1 is a side view illustrating an example of a traveling vehicle system according to the present embodiment.
Fig. 2 is a perspective view of a ceiling traveling vehicle for use in the traveling vehicle system according to the present embodiment.
Fig. 3 is a perspective view illustrating an example of the traveling vehicle system according to the present embodiment.
Fig. 4 illustrates a traveler and a coupler of the ceiling traveling vehicle in an enlarged manner: (A) is a plan view; and (B) is a front elevational view.
Fig. 5 is a plan view illustrating an example of a positional relation among a first track, a second track, a connection track, and a guider.
Fig. 6 is a plan view illustrating an example of the guider when a traveling wheel is turned.
Fig. 7 is a side view illustrating a positional relation between two gaps and two guiders.
Fig. 8 is a diagram illustrating a state in which a traveling direction of the ceiling traveling vehicle is a first direction.
Fig. 9 is a diagram illustrating an operation to change the traveling direction of the ceiling traveling vehicle from a second direction to the first direction.
Fig. 10 is a diagram illustrating guide rollers during the turning of traveling wheels.
Fig. 11 is a diagram illustrating a state in which the traveling direction of the ceiling traveling vehicle is the second direction.
Fig. 12 is a diagram illustrating another example of the guider and a first guide face or a second guide face. Description of Embodiments

The following describes an embodiment of the present invention with reference to the accompanying drawings. However, the present invention is not limited to the aspects described in the following. To describe the embodiment, the drawings are represented with the scale changed as appropriate such as in a partially enlarged or emphasized manner. In the drawings below, directions in the drawings are described using an XYZ coordinate system. In this XYZ coordinate system, a plane parallel to a horizontal plane is defined as an XY plane. One direction along this XY plane is denoted by an X direction, whereas a direction orthogonal to the X direction is denoted by a Y direction. A traveling direction of a ceiling traveling vehicle 100 can be changed to another direction from the direction illustrated in the drawings below; the ceiling traveling vehicle 100 may travel in a curved direction, for example. A direction perpendicular to the XY plane is denoted by a Z direction. Each of the X direction, the Y direction, and the Z direction is described with the direction indicated by the arrow in the drawings as a + direction and with the direction opposite to the direction indicated by the arrow as a - direction. A turning direction about a perpendicular axis or about a Z axis is denoted by a θZ direction.

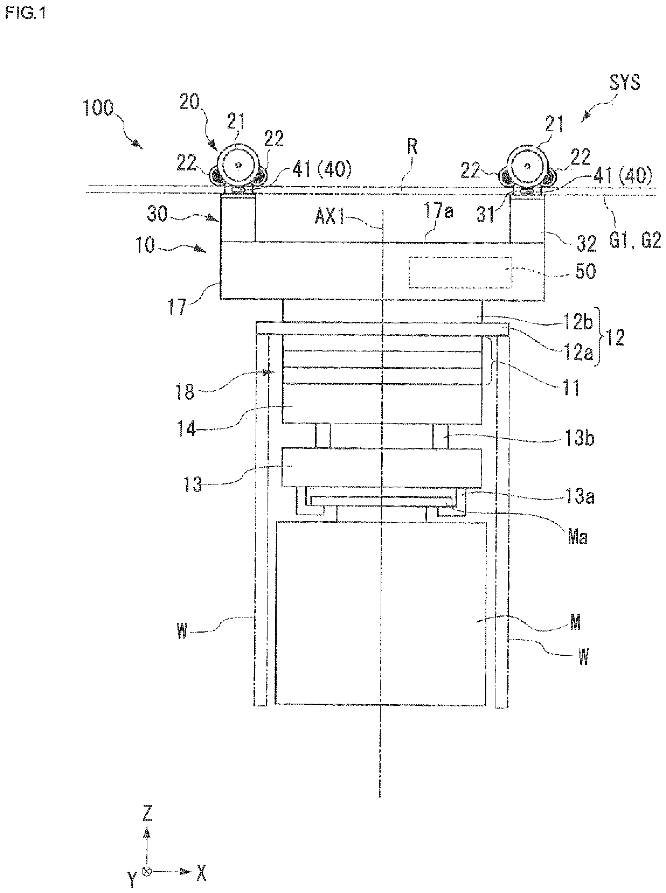

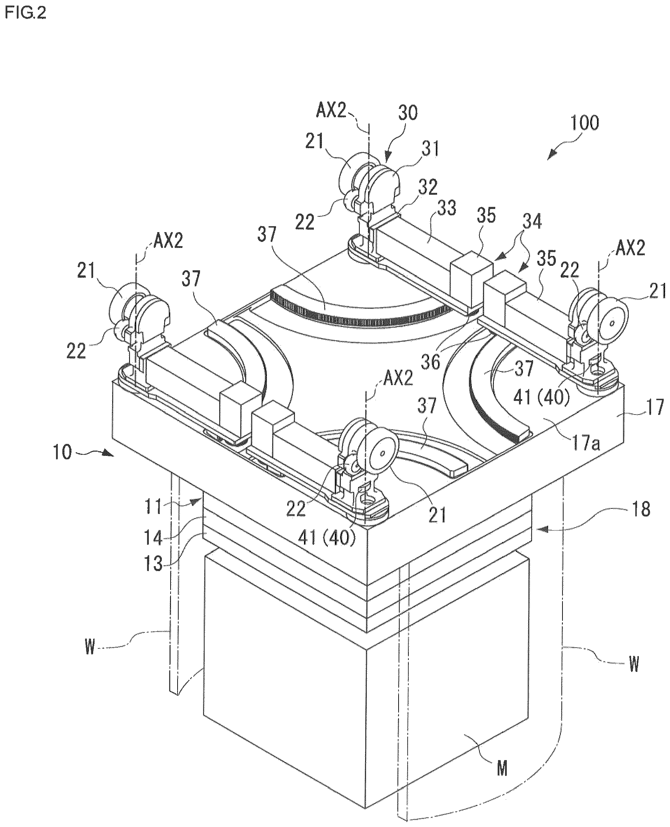

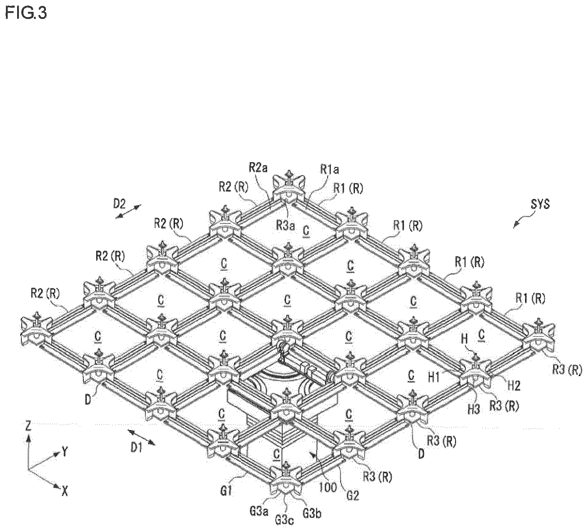

Fig. 1 is a side view illustrating an example of a traveling vehicle system SYS according to the present embodiment. Fig. 2 is a perspective view of the ceiling traveling vehicle 100 for use in the traveling vehicle system SYS illustrated in Fig. 1. Fig. 3 is a perspective view illustrating an example of the traveling vehicle system SYS according to the present embodiment. As illustrated in Fig. 1 to Fig. 3, the ceiling traveling vehicle 100 moves along a track R of the traveling vehicle system SYS to convey an article M such as a front opening unified pod (FOUP) housing semiconductor wafers or a reticle pod housing reticles. The ceiling traveling vehicle 100 conveys the article M and may thus be referred to as a ceiling conveyance vehicle.

The traveling vehicle system SYS is a system to convey the article M by the ceiling traveling vehicle 100 in a clean room of a semiconductor manufacturing factory, for example. In the traveling vehicle system SYS, a plurality of ceiling traveling vehicles 100 may be used, for example. The ceiling traveling vehicles 100 convey the article M, thereby enabling high-density conveyance, and enabling improvement in the conveyance efficiency of the article M.

The track R is one aspect of a track. The track R is laid on the ceiling or near the ceiling of a building such as a clean room. The track R is a grid-like track including a first track R1, a second track R2, and a connection track R3 (refer to Fig. 3). Hereinafter, the track R is referred to as a grid-like track R. The first track R1 is provided along the X direction (a first direction D1). The second track R2 is provided along the Y direction (a second direction D2). In the present embodiment, the first direction D1 and the second direction D2 are orthogonal to each other, and a plurality of first tracks R1 and a plurality of second tracks R2 are orthogonal to each other. The connection track R3 is placed at a crossing part of the first track R1 and the second track R2. The connection track R3 is adjacent to the first track R1 in the first direction D1 and is adjacent to the second track R2 in the second direction D2. The connection track R3 connects the first track R1 and the second track R2 to each other. The first tracks R1 and the second tracks R2 are orthogonal to each other, whereby the grid-like track R is in a state in which a plurality of cells C are adjacent to each other in a plan view. Fig. 3 illustrates part of the grid-like track R, and in the grid-like track R, a similar configuration is continuously formed in the first direction D1 (the X direction) and the second direction D2 (the Y direction) from the illustrated configuration.

The first track R1, the second track R2, and the connection track R3 are hung from the ceiling (not illustrated) by a hanging member H (refer to Fig. 3). The hanging member H has a first part H1 to hang the first track R1, a second part H2 to hang the second track R2, and a third part H3 to hang the connection track R3. First parts H1 and second parts H2 are each provided at two places across the third part H3.

The first track R1, the second track R2, and the connection track R3 have traveling faces R1a, R2a, and R3a, respectively, on which a traveling wheel 21 described below of the ceiling traveling vehicle 100 travels. A gap D is formed between the first track R1 and the connection track R3 and between the second track R2 and the connection track R3. The gap D is a part through which a coupler 30 described below as part of the ceiling traveling vehicle 100 passes when the ceiling traveling vehicle 100 travels along the first track R1 to cross the second track R2 or when the ceiling traveling vehicle 100 travels along the second track R2 to cross the first track R1. Consequently, the gap D is provided in a width enabling the coupler 30 to pass therethrough. The first track R1, the second track R2, and the connection track R3 are provided along the same or substantially the same horizontal plane. In the present embodiment, the first track R1, the second track R2, and the connection track R3 place the traveling faces R1a, R2a, and R3a on the same or substantially the same horizontal plane.

The track R has a first guide face G1 and a second guide face G2. The first guide face G1 is provided along the first track R1. In the present embodiment, the first guide face G1 is provided on a side face of the first track R1. The second guide face G2 is provided along the second track R2. In the present embodiment, the second track R2 is provided on a side face of the second guide face G2.

The connection track R3 has a first connection guide face G3a, a second connection guide face G3b, and a continuous face G3c. In the present embodiment, the first connection guide face G3a is provided at the same height (including substantially the same height) and in the same direction (including substantially the same direction) the first guide face G1. That is, the first connection guide face G3a and the first guide face G1 are included in the same plane. The second connection guide face G3b is provided at the same height (including substantially the same height) and in the same direction (including substantially the same direction) as the second guide face G2. That is, the second connection guide face G3b and the second guide face G2 are included in the same plane. The continuous face G3c is formed so as to make the first connection guide face G3a and the second connection guide face G3b continuous with each other. The continuous face G3c is a curved face smoothly connecting the first connection guide face G3a and the second connection guide face G3b to each other. Details of the first connection guide face G3a, the second connection guide face G3b, and the continuous face G3c of the connection track R3 will be described below.

As illustrated in Fig. 1 and Fig. 2, the ceiling traveling vehicle 100 has a main body 10, travelers 20, couplers 30, guiders 40, and a controller 50. The controller 50 collectively controls operations of the respective parts of the ceiling traveling vehicle 100. Although the controller 50 is provided in the main body 10, it may be provided outside the main body 10. The main body 10 is placed below (on the -Z side of) the grid-like track R. The main body 10 is formed in a rectangular shape, for example, in a plan view. The main body 10 is formed in dimensions housed in one cell C in the grid-like track R in a plan view. Thus, space in which one ceiling traveling vehicle 100 passes another ceiling traveling vehicle 100 traveling along an adjacent first track R1 or second track R2 is ensured. The main body 10 includes an upper unit 17 and a transfer apparatus 18. The upper unit 17 is hung on the travelers 20 via the couplers 30. The upper unit 17 is rectangular in a plan view, for example, and has four corner parts 10a in an upper face 17a.

The main body 10 has the traveling wheel 21, the coupler 30, a direction changer 34, and a guider 40 at each of the four corner parts 10a. In this configuration, traveling wheels 21 placed at the four respective corner parts 10a of the main body 10 can stably hang the main body 10 and can cause the main body 10 to stably travel. The guiders 40 placed at the four respective corner parts 10a of the main body 10 can effectively prevent the positional deviation of the main body 10 in the first direction D1 or the second direction D2 with respect to the grid-like track R and the positional deviation of the main body 10 about the perpendicular axis with respect to the grid-like track R. Details of the guider 40 will be described below.

The transfer apparatus 18 is provided below the upper unit 17. The transfer apparatus 18 can rotate about a rotation axis AX1 in the Z direction (a vertical direction). The transfer apparatus 18 has an article holder 13 holding the article M, a hoisting-and-lowering driver 14 hoisting and lowering the article holder 13 in the vertical direction, a lateral mover 11 slidingly moving the hoisting-and-lowering driver 14 in a horizontal direction, and a rotator 12 holding the lateral mover 11. The article holder 13 grasps a flange part Ma of the article M to hang and hold the article M. The article holder 13 is a chuck having a horizontally movable hook part 13a, for example, causes the hook part 13a to enter below the flange part Ma of the article M, and hoists the article holder 13 to hold the article M. The article holder 13 is connected to a hanging member 13b such as a wire or a belt.

The hoisting-and-lowering driver 14 is a hoist, for example, draws out the hanging member 13b to lower the article holder 13, and winds up the hanging member 13b to hoist the article holder 13. The hoisting-and-lowering driver 14 is controlled by the controller 50 to lower or hoist the article holder 13 at a certain speed. The hoisting-and-lowering driver 14 is controlled by the controller 50 to hold the article holder 13 at a target height.

The lateral mover 11 has a plurality of movable plates stacked and placed in the Z direction, for example. The movable plates are relatively movable in the Y direction. The hoisting-and-lowering driver 14 is mounted on a lowermost movable plate. The lateral mover 11 moves the movable plates by a drive apparatus (not illustrated) and can thus laterally move (slidingly move) the hoisting-and-lowering driver 14 mounted on the lowermost movable plate and the article holder 13 in the horizontal direction orthogonal to the traveling direction, for example.

The rotator 12 is provided between the lateral mover 11 and the upper unit 17. The rotator 12 has a rotating member 12a and a rotational driver 12b. The rotating member 12a is provided rotatably in a direction about an axis in the vertical direction. The rotating member 12a supports the lateral mover 11. The rotational driver 12b, for which an electric motor or the like is used, rotates the rotating member 12a in a direction about the rotation axis AX1. The rotator 12 rotates the rotating member 12a through a driving force from the rotational driver 12b and can thus rotate the lateral mover 11 (the hoisting-and-lowering driver 14 and the article holder 13) in the direction about the rotation axis AX1.

As illustrated in Fig. 1 and Fig. 2, a cover W may be provided so as to surround the transfer apparatus 18 and the article M held by the transfer apparatus 18. The cover W has a tubular shape with a lower end open with a part through which the movable plates of the lateral mover 11 protrude notched. The cover W, the upper end of which is mounted on the rotating member 12a of the rotator 12, rotates about an axis of the rotation axis AX1 along with the rotation of the rotating member 12a.

A traveler 20 has the traveling wheel 21 and auxiliary wheels 22. The traveling wheels 21 are placed at the four respective corner parts 10a of the upper face 17a of the upper unit 17 (the main body 10). Each of the traveling wheels 21 is mounted on a wheel shaft 21a provided in the coupler 30. The wheel shaft 21a is provided parallel or substantially parallel to the XY plane. Each of the traveling wheels 21 is rotationally driven by the driving force of a traveling driver 33 described below. Each of the traveling wheels 21 rolls on the traveling faces R1a, R2a, and R3a of the first track R1, the second track R2, and the connection track R3, respectively, in the track R to cause the ceiling traveling vehicle 100 to travel. Without being limited to rotationally driving all of the four traveling wheels 21 by the driving force of the traveling driver 33, some of the four traveling wheels 21 may be rotationally driven.

The traveling wheel 21 is provided turnably in the θZ direction about a turning axis AX2. The traveling wheel 21 turns in the θZ direction by the direction changer 34 described below and can consequently change the traveling direction of the ceiling traveling vehicle 100. The auxiliary wheels 22 are placed with one each on the front and rear in the traveling direction of the traveling wheel 21. Each of the auxiliary wheels 22, like the traveling wheel 21, is rotatable about an axis of a wheel shaft 22a parallel or substantially parallel to the XY plane. A lower end of the auxiliary wheels 22 is set to be higher than a lower end of the traveling wheel 21. Consequently, when the traveling wheel 21 is traveling on the traveling faces R1a, R2a, and R3a, the auxiliary wheels 22 are not in contact with the traveling face R1a, R2a, or R3a. When the traveling wheel 21 passes through the gap D, the auxiliary wheels 22 come into contact with the traveling faces R1a, R2a, and R3a to prevent the traveling wheel 21 from falling. Without being limited to providing two auxiliary wheels 22 for one traveling wheel 21, one auxiliary wheel 22 may be provided for one traveling wheel 21, or no auxiliary wheels 22 may be provided, for example.

The couplers 30 couple the upper unit 17 of the main body 10 and the travelers 20 to each other. The couplers 30 are provided at the four respective corner parts 10a of the upper face 17a of the upper unit 17 (the main body 10). The main body 10 is made to be hung from the travelers 20 by these couplers 30 to be placed below the grid-like track R. The coupler 30 has a support member 31 and a connection member 32. The support member 31 rotatably supports a rotation axis of the traveling wheel 21 and rotation axes of the auxiliary wheels 22. The support member 31 holds a relative position among the traveling wheel 21 and the auxiliary wheels 22. The support member 31 is formed in a plate shape, for example, and is formed in a thickness that enables it to pass through the gap D.

The connection member 32 extends downward from the support member 31 to be coupled to the upper face 17a of the upper unit 17 and to hold the upper unit 17. The connection member 32 includes a transmitter transmitting the driving force of the traveling driver 33 described below to the drive wheel 21 therewithin. For this transmitter, a chain or a belt may be used, or a gear train may be used. The connection member 32 is provided turnably in the θZ direction about the turning axis AX2. This connection member 32 turns about the turning axis AX2, thereby enabling the traveling wheel 21 to turn in the θZ direction about the turning axis AX2 via the support member 31.

The coupler 30 is provided with the traveling driver 33 and the direction changer 34. The traveling driver 33 is mounted on the connection member 32. The traveling driver 33 is a driving source driving the traveling wheel 21, and an electric motor or the like is used therefor, for example. The four traveling wheels 21 are each driven by the traveling driver 33 to be drive wheels. The four traveling wheels 21 are controlled by the controller 50 so as to have the same or substantially the same number of rotations. When any of the four traveling wheels 21 is not used as a drive wheel, the traveling driver 33 is not mounted on the connection member 32 corresponding to the traveling wheel 21 not used as a drive wheel.

The direction changer 34 turns the connection member 32 of the coupler 30 about the turning axis AX2 to turn the traveling wheels 21 in the θZ direction about the turning axis AX2. The traveling wheel 21 is turned in the θZ direction, whereby the first state, in which the traveling direction of the ceiling traveling vehicle 100 is the first direction D1, can be switched to the second state, in which the traveling direction thereof is the second direction D2, or the second state, in which the traveling direction thereof is the second direction D2, can be switched to the first state, in which the traveling direction thereof is the first direction D1.

The direction changer 34 has a driving source 35, a pinion gear 36, and a rack 37. The driving source 35 is mounted on a side face of the traveling driver 33 away from the turning axis AX2. For the driving source 35, an electric motor or the like is used, for example. The pinion gear 36 is mounted on a lower face side of the driving source 35 and is rotationally driven in the θZ direction through a driving force generated by the driving source 35. The pinion gear 36 is circular in a plan view and has a plurality of teeth in a circumferential direction on its perimeter. The rack 37 is fixed to the upper face 17a of the upper unit 17. Racks 37 are provided at the four respective corner parts 10a of the upper face 17a of the upper unit 17 and are each provided in an arc shape (a fan shape) about the turning axis AX2 of the traveling wheel 21. The rack 37 has a plurality of teeth meshing with the teeth of the pinion gear 36 in a circumferential direction on its perimeter.

The pinion gear 36 and the rack 37 are placed with the mutual teeth meshing with each other. The pinion gear 36 rotates in the θZ direction, whereby the pinion gear 36 moves in a circumferential direction about the turning axis AX2 so as to follow the perimeter of the rack 37. With this movement of the pinion gear 36, the connection member 32 turns, and the traveling driver 33 and the direction changer 34 turn in the circumferential direction about the turning axis AX2 together with the pinion gear 36.

By the turning of the direction changer 34, the traveling wheels 21 and the auxiliary wheels 22 placed at the four respective corner parts 10a of the upper face 17a each turn in a range of 90 degrees in the θZ direction about the turning axis AX2. The drive of the direction changer 34 is controlled by the controller 50. The controller 50 may instruct to perform turning operations of the four traveling wheels 21 at the same time or instruct to perform them at different times. The traveling wheels 21 and the auxiliary wheels 22 are turned, whereby a state in which the traveling wheels 21 are in contact with one of the first track R1 and the second track R2 shifts to a state in which the traveling wheels 21 are in contact with the other. In other words, a state in which the direction of the rotation axis of the traveling wheel 21 is one of the first direction D1 and the second direction D2 shifts to a state in which the direction of the rotation axis of the traveling wheel 21 is the other. Thus, the first state, in which the traveling direction of the ceiling traveling vehicle 100 is the first direction D1 (the X direction), and the second state, in which the traveling direction thereof is the second direction D2 (the Y direction), can switch each other.

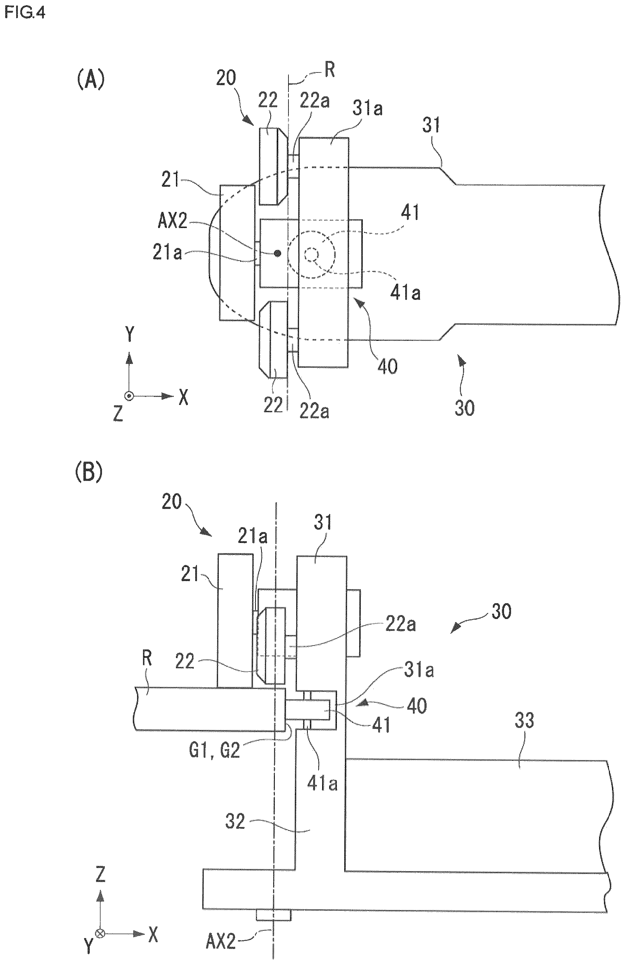

Fig. 4 is a diagram illustrating an example of the traveler 20 and the coupler 30: (A) is a plan view; and (B) is a front elevational view. As illustrated in Fig. 4, the support member 31 of the coupler 30 is provided with a guider container 31a. The guider 40 prevents the positional deviation of the coupler 30 with respect to the grid-like track R and thus prevents the positional deviation of the main body 10 with respect to the grid-like track R. The guider 40 is provided in each of the couplers 30 placed at the four respective corner parts 10a of the upper face 17a of the main body 10 (refer to Fig. 1 and Fig. 2). The guider 40 moves along the first guide face G1 and the first connection guide face G3a in the first state, in which the traveling wheel 21 travels along the first track R1. The guider 40 moves along the second guide face G2 and the second connection guide face G3b in the second state, in which the traveling wheel 21 travels along the second track R2. While the main body 10 is traveling, the guider 40 may be in contact with the first guide face G1 or the second guide face G2 or be spaced apart from the first guide face G1 or the second guide face G2.

The guider 40 has a guide roller 41 contained in the guider container 31a of the support member 31. The guide roller 41 is contained in the guider container 31a and is placed with an end on the -X side protruding from the guider container 31a. The guide roller 41 is rotatably supported about the Z axis by a roller shaft 41a. The roller shaft 41a is fixed to the inside of the guider container 31a and is placed in parallel to the Z direction.

The roller shaft 41a may be supported by an elastic member, for example. With this configuration, the guide roller 41 is supported movably in the X direction and rotatably, and the impact of the guide roller 41 hitting the first guide face G1 or the like can be absorbed by the elastic member. The guide roller 41 is a driven roller having no driving source rotating the guide roller 41. However, a driver rotationally driving the guide roller 41 in accordance with a traveling direction of the main body 10 may be included.

The guide roller 41 is placed at a height between the wheel shaft 21a of the traveling wheel 21 and the main body 10. The first guide face G1 and the second guide face G2 are placed at a height between the wheel shaft 21a of the traveling wheel 21 and the main body 10. The guide roller 41 is placed at a position corresponding to the height of the first guide face G1 and the second guide face G2 in the coupler 30. The guide roller 41 is placed at the height between the wheel shaft 21a of the traveling wheel 21 and the main body 10, whereby the dimension of the coupler 30 or the traveler 20 in an up-and-down direction is prevented from increasing, and a reduction in space efficiency near a ceiling of a building or the like is prevented.

The roller shaft 41a is provided in the coupler 30, whereby when the orientation of the traveling wheel 21 is changed by the direction changer 34, that is, when the coupler 30 is turned by the direction changer 34, the guider 40 (the guide roller 41) turns about the turning axis AX2 together with the turning of the traveling wheel 21. Consequently, in the first state, in which the traveling wheel 21 travels along the first track R1, the guide roller 41 faces the first guide face G1 and the first connection guide face G3a, whereas in the second state, in which the traveling wheel 21 travels along the second track R2, the guide roller 41 faces the second guide face G2 and the second connection guide face G3b. Thus, the guide roller 41 is turned using the direction changer 34 to switch a traveling state of the traveling wheel 21, and thus there is no need to provide a separate mechanism in order to turn the guide roller 41, thus preventing the configuration of the main body 10 from being complicated.

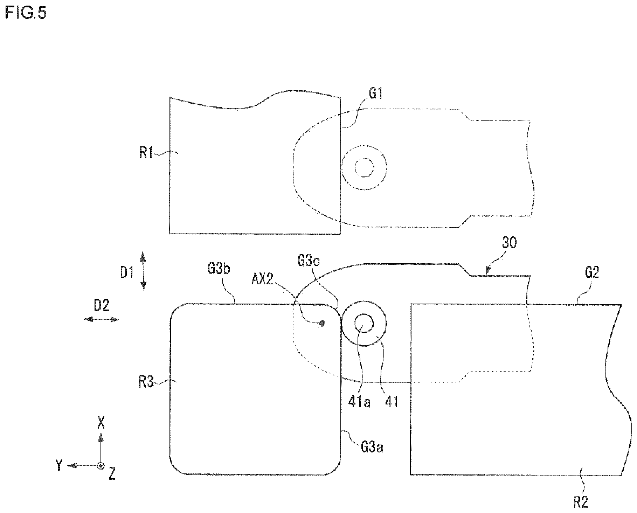

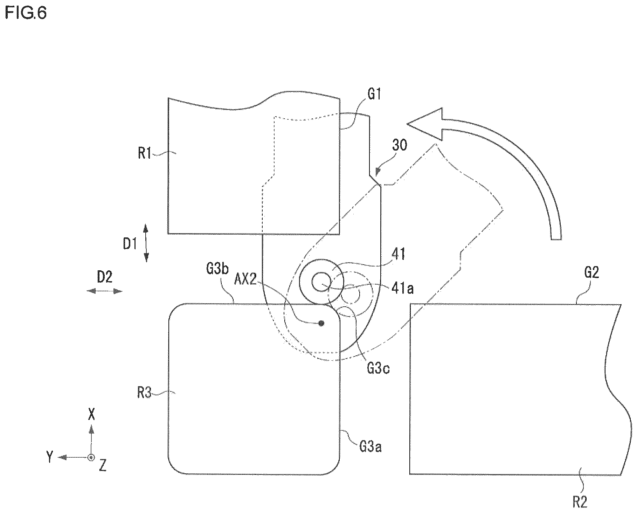

Fig. 5 is a plan view illustrating an example of a positional relation among the first track R1, the second track R2, the connection track R3, and the guide roller 41. Fig. 6 is a plan view illustrating an example of the guider 40 (the guide roller 41) when the traveling wheel 21 is turned. As illustrated in Fig. 5 and Fig. 6, a part of the guide roller 41 protruding from the guider container 31a of the support member 31 can be in contact with the first guide face G1 as the side face of the first track R1, the second guide face G2 as the side face of the second track R2, the first connection guide face G3a, the second connection guide face G3b, and the continuous face G3c as the side faces of the connection track R3. In Fig. 5 and Fig. 6, the representation of the guider container 31a of the support member 31 is omitted.

As illustrated in Fig. 5, when the main body 10 travels in the first direction D1 (in the first state, in which the traveling wheel 21 rolls on the first track R1), the guide roller 41 moves along the first guide face G1 or the first connection guide face G3a. In this first state, the part of the guide roller 41 protruding from the guider container 31a can be in contact with the first guide face G1 and the first connection guide face G3a. The guide roller 41 can rotate when coming into contact with the first guide face G1 and the first connection guide face G3a, thus reducing frictional resistance during contact while the main body 10 is traveling and preventing a load on the traveling driver 33 from increasing while reducing the generation of particles.

When the main body 10 moves in the second direction D2 in the state illustrated in Fig. 5, the guide roller 41 comes into contact with the first guide face G1 or the first connection guide face G3a, whereby the positional deviation of the main body 10 in the second direction D2 is limited. That is, the main body 10 has a pair of guide rollers 41 in the second direction D2, and the guide rollers 41 come into contact with the first guide face G1 or the first connection guide face G3a faced by the guide rollers 41, and thus the positional deviation of the main body 10 in the +Y direction and the -Y direction is prevented. Consequently, positional deviation in the second direction D2 is limited even when the main body 10 is stationary at any part of the grid-like track R, not to mention while the main body 10 is traveling in the first direction D1.

As illustrated in Fig. 6, when the main body 10 is caused to travel along the second direction D2 from the state in which the main body 10 is traveling in the first direction D1 (in the case of the second state, in which the traveling wheel 21 rolls on the second track R2), the traveling wheel 21 is turned by the direction changer 34. In this process, the coupler 30 is turned by the direction changer 34, whereby the guide roller 41 also turns about the turning axis AX2. The guide roller 41 moves from the first connection guide face G3a to the second connection guide face G3b via the continuous face G3c.

In this case, the continuous face G3c is a curved face smoothly connecting the first connection guide face G3a and the second connection guide face G3b to each other, and thus the guide roller 41 can smoothly be moved while being rotated. In the present embodiment, the continuous face G3c is formed in an arc shape in a plan view, and thus the movement of the guide roller 41 can be performed more smoothly. The shape of the continuous face G3c is not limited to the illustrated shape, may be a curved face other than the arc shape in a plan view, or may be a non-smooth shape such as a plurality of planes connected to form corner parts, for example.

The continuous face G3c need not be formed. That is, the first connection guide face G3a and the second connection guide face G3b are separate from each other, for example; thus, the two need not be continuous with each other. In this case, when moving from the first connection guide face G3a to the second connection guide face G3b or when moving from the second connection guide face G3b to the first connection guide face G3a, the guide roller 41 temporarily becomes noncontact with these guide faces.

As illustrated in Fig. 6, the guide roller 41 moves to a state along the second connection guide face G3b, whereby the main body 10 becomes a state in which the main body 10 can travel along the second direction D2 (the second state, in which the traveling wheel 21 rolls on the second track R2). In this second state, the part of the guide roller 41 protruding from the guider container 31a can be in contact with the second guide face G2 and the second connection guide face G3b. Like the above, the guide roller 41 can rotate when coming into contact with the second guide face G2 and the second connection guide face G3b, thus reducing frictional resistance during contact while the main body 10 is traveling and preventing a load on the traveling driver 33 from increasing.

When the main body 10 moves in the first direction D1 in the state illustrated in Fig. 6, the guide roller 41 comes into contact with the second guide face G2 or the second connection guide face G3b, whereby the positional deviation of the main body 10 in the first direction D1 is limited. That is, the main body 10 has a pair of guide rollers 41 in the first direction D1, and the guide rollers 41 come into contact with the second guide face G2 or the second connection guide face G3b faced by the guide rollers 41, and thus the positional deviation of the main body 10 in the +X direction and the -X direction is prevented. Consequently, positional direction in the first direction D1 is limited even when the main body 10 is stationary at any part of the grid-like track R, not to mention while the main body 10 is traveling in the second direction D2.

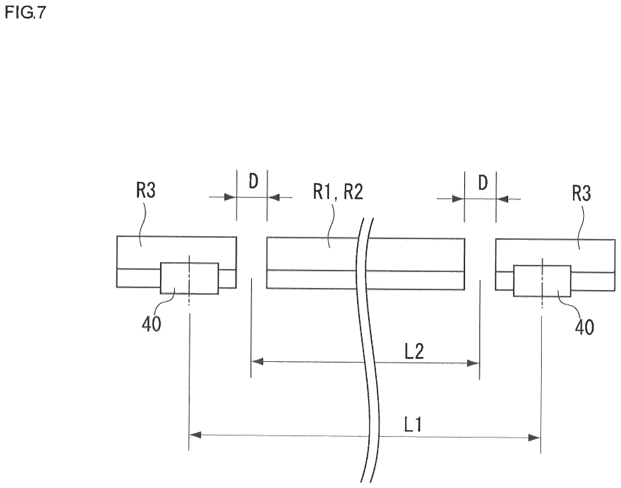

Fig. 7 is a side view illustrating an example of a positional relation between the track R and the guide roller 41. As illustrated in Fig. 7, a spacing L1 between two guide rollers 41 arranged in the traveling direction among the four guide rollers 41 is set to be different from a spacing L2 of gaps D adjacent to each other in the first direction D1 or the second direction D2. With this configuration, the two guide rollers 41 arranged in the traveling direction are prevented from being simultaneously positioned at the gaps D. Although the example illustrated in Fig. 7 illustrates a case in which the spacing L1 of the guide rollers 41 is larger than the spacing L2 of the gaps D, this aspect is not limiting; the spacing L1 of the guide rollers 41 may be smaller than the spacing L2 of the gaps D.

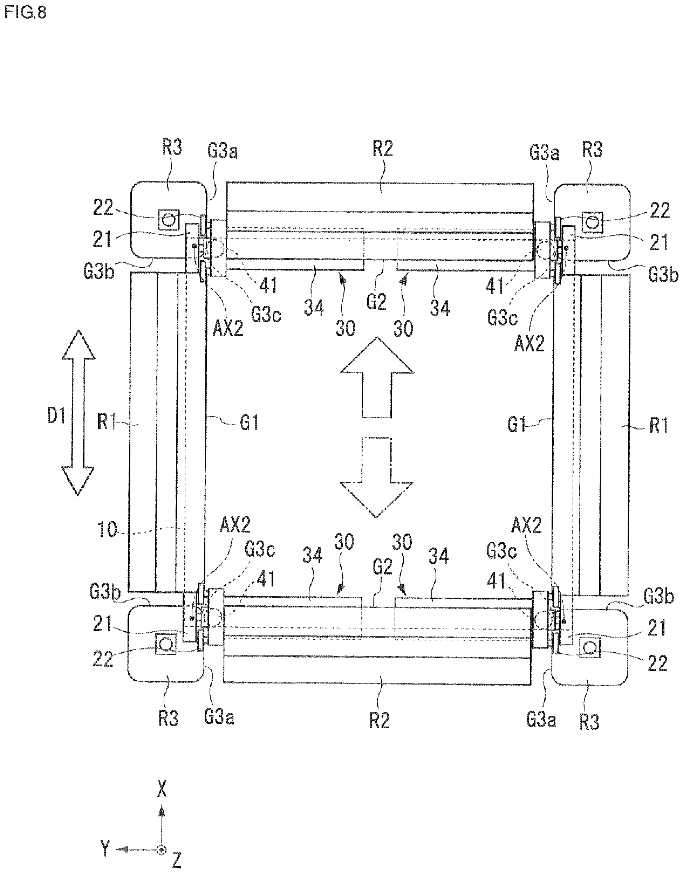

The following describes a case in which the ceiling traveling vehicle 100 changes its traveling direction in the traveling vehicle system SYS according to the present embodiment. Fig. 8 to Fig. 11 are diagrams illustrating an operation to change the traveling direction of the ceiling traveling vehicle 100 from the first direction D1 to the second direction D2. As illustrated in Fig. 8, the ceiling traveling vehicle 100 stops at a position at which the main body 10 traveling along the first track R1 in the first direction D1 (the +X direction or the -X direction) has reached one cell C (refer to Fig. 3) of the grid-like track R (a position at which the four corner parts 10a have approached respective connection tracks R3). That is, the controller 50 (refer to Fig. 1) stops the drive of the traveling driver 33 at the position described above. At this moment, all the four traveling wheels 21 are in contact with the respective connection tracks R3. The four guide rollers 41 are each placed at a position along the first connection guide face G3a of the connection track R3.

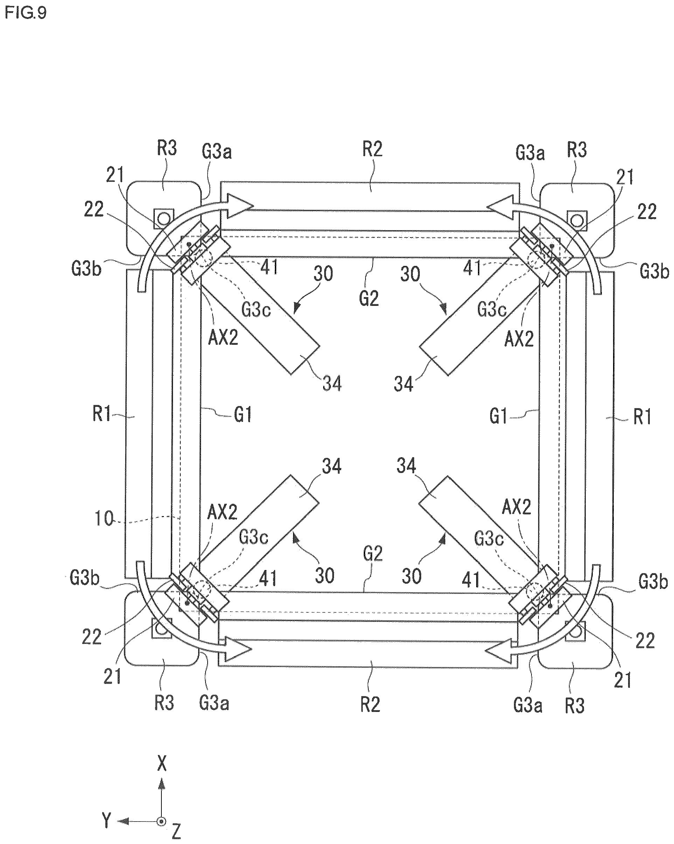

Next, as illustrated in Fig. 9, the controller 50 drives the direction changer 34 to turn the couplers 30 and to turn the traveling wheels 21 and the auxiliary wheels 22 placed at the four respective corner parts 10a in the θZ direction about the turning axis AX2. In this process, the traveling wheels 21 and the like that are diagonally placed turn in the same direction. Among the four traveling wheels 21, the upper left traveling wheel 21 and the like and the lower right traveling wheel 21 and the like in the drawing turn clockwise, for example. On the other hand, the upper right traveling wheel 21 and the like and the lower left traveling wheel 21 and the like in the drawing turn counterclockwise. Such turning operations may be performed at the same time or performed at different times, for example, the upper left and lower right traveling wheels 21 and the like in the drawing may be turned first simultaneously, and then the upper right and lower left traveling wheels 21 and the like in the drawing may be turned simultaneously.

During the turning of the traveling wheels 21 and the auxiliary wheels 22, the four guide rollers 41 each turn about the turning axis AX2 integrally with the respective couplers 30 and move along the continuous face G3c. Consequently, the guide rollers 41 turn to switch their directions simultaneously with the turning of the traveling wheels 21 and the auxiliary wheels 22. The guide rollers 41 move along respective continuous faces G3c, thus ensuring smooth movement of the guide rollers 41. The turning of the guide rollers 41 do not hinder the turning operations of the traveling wheels 21 and the like. The turning of the traveling wheels 21 and the like and the turning of the guide rollers 41 are performed by common respective direction changers 34, and thus there is no need to separately provide a structure to change the directions of the guide rollers 41, thus avoiding the configuration of the main body 10 from being complicated.

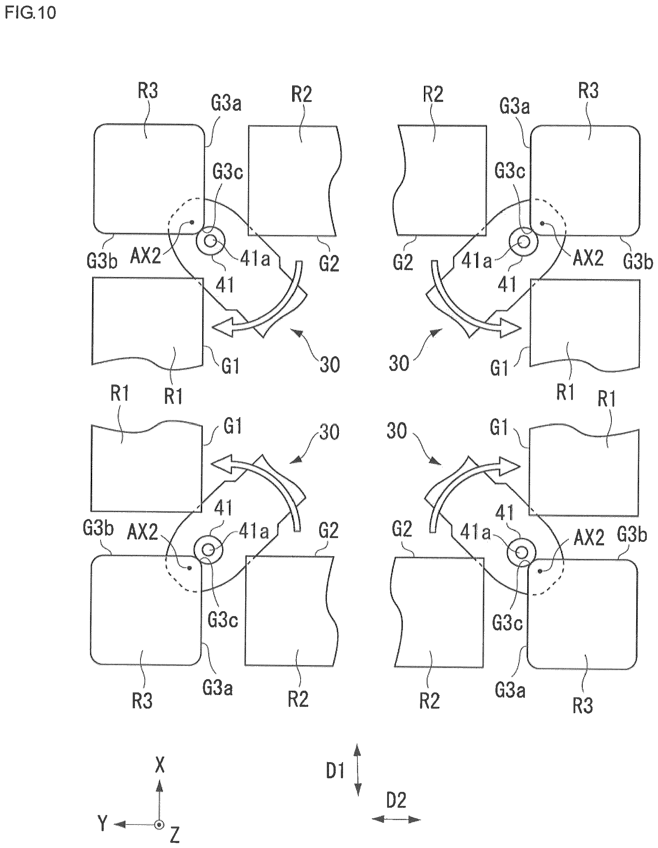

Fig. 10 is a diagram illustrating the guide rollers 41 during the turning of the traveling wheels 21. As illustrated in Fig. 10, the turning operations of the four traveling wheels 21 are performed at the same time, whereby the four guide rollers 41 provided in the respective couplers 30 synchronously change their orientations. Consequently, during the turning operation (during steering) of the traveling wheels 21, the guide rollers 41 face the respective connection tracks R3 (continuous faces G3c), and thus the positional deviation of the main body 10 is prevented. During the turning operations of the traveling wheels 21, the guide rollers 41 move along the respective continuous faces G3c, whereby the positional deviation of the main body 10 can surely be prevented during the turning operations of the traveling wheels 21.

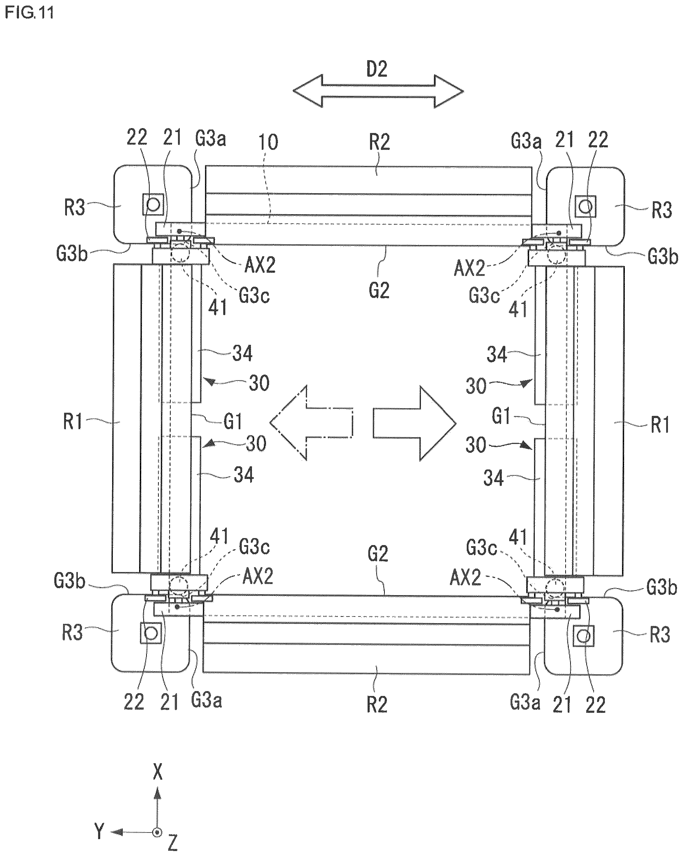

Next, as illustrated in Fig. 11, after the traveling wheels 21 and the like have each turned by 90° in the θZ direction, the controller 50 stops the drive of the direction changers 34. The traveling driver 33 is driven in this state, whereby the ceiling traveling vehicle 100 becomes able to travel in the second direction D2 (the +Y direction or the -Y direction). The four guide rollers 41 are each placed at a position along the second connection guide face G3b of the connection track R3. Even when the traveling wheels 21 and the like turn, the main body 10 does not turn. Consequently, in either case when the ceiling traveling vehicle 100 travels in the first direction D1 or when the ceiling traveling vehicle 100 travels in the second direction D2, the orientation of the main body 10 remains unchanged.

Thus, with the traveling vehicle system SYS according to the present embodiment, the guide roller 41 of the guider 40 rotates integrally with the coupler 30, and thus without any separate structure to change the direction of the guide roller 41, the direction of the guide roller 41 can be switched in accordance with the direction change of the traveling wheel 21. Consequently, the positional deviation of the main body 10 can be prevented by a simple configuration while avoiding the configuration of the ceiling traveling vehicle 100 from being complicated. Although Fig. 8 to Fig. 11 illustrate a case in which the ceiling traveling vehicle 100 changes its traveling direction from the first direction D1 to the second direction D2, the same also holds true for a case in which the ceiling traveling vehicle 100 changes its traveling direction from the second direction D2 to the first direction D1.

Although the embodiment describes a configuration in which the first guide face G1 and the second guide face G2 are the side face of the first track R1 and the side face of the second track R2 as an example, respectively, this aspect is not limiting.

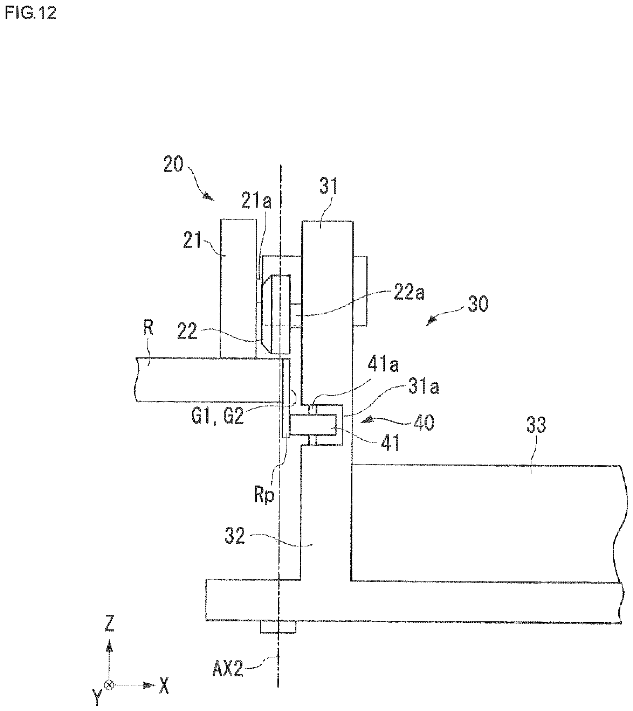

Fig. 12 is a diagram illustrating another example of the track R, the traveler 20, and the coupler 30. As illustrated in Fig. 12, a guide plate Rp may be mounted on the side faces of the first track R1 and the second track R2 out of the track R, and a surface of the guide plate Rp may be set as the first guide face G1 or the second guide face G2. In this case, the guide plate Rp is placed extending downward (the -Z side) from the side faces of the first track R1 and the second track R2. Consequently, the first guide face G1 and the second guide face G2 can be set below the first track R1 and the second track R2. Also in the connection track R3, a guide plate (not illustrated) extending downward from the side faces of the track is mounted to form the first connection guide face G3a, the second connection guide face G3b, and the continuous face G3c.

In the configuration illustrated in Fig. 12, the position of the guide roller 41 in a height direction is determined along the first guide face G1 and the second guide face G2 (including the first connection guide face G3a, the second connection guide face G3b, and the continuous face G3c not illustrated). Consequently, the guide roller 41 is placed below the first track R1 and the second track R2. The first guide face G1 and the like are not limited to being placed below the first track R1 and the like. The guide plate Rp may be placed above the first track R1 and the like, for example. In this case, the guide plate Rp may be held by the first track R1 and the like via a support member or the like.

Although the embodiment has been described, the present invention is not limited to the description described above, and various modifications can be made to the extent not departing from the gist of the present invention. Although the embodiment describes a configuration in which the guiders 40 are placed at the four respective couplers 30 as an example, this configuration is not limiting. The guiders 40 may be placed at any one to three of the four couplers 30, for example.

Although the embodiment describes a configuration in which the guide roller 41 rotating about an axis of the roller shaft 41a is provided as the guider 40 as an example, this aspect is not limiting. The guider 40 may be a nonrotating aspect such as a protruding part formed on the support member 31 of the coupler 30, for example. For this protruding part, a protruding portion is formed in a spherical or curved face shape, or a shape reducing frictional resistance with the first guide face G1 and the like may be used. The guider 40 may be placed with a certain spacing provided with respect to each of the first guide face G1, the second guide face G2, the first connection guide face G3a, the second connection guide face G3b, and the continuous face G3c.

Although the embodiment describes the grid-like track R in which the first track R1 (the first direction D1) and the second track R2 (the second direction D2) are orthogonal to each other as an example, this configuration is not limiting. The track R may be an aspect in which the first track R1 and the second track R2 are not orthogonal to each other, for example. Without being limited to the grid-like track R in which the first track R1 and the second track R2 cross each other, the track R may be an aspect in which the second track R2 is placed bent from an end of the first track R1, for example.

embodiment and the like described above may be omitted. The requirements described in the embodiment and the like described above can be combined with each other as appropriate.

### Description of Reference Signs

D: GAP
D1: FIRST DIRECTION
D2: SECOND DIRECTION
G1: FIRST GUIDE FACE
G2: SECOND GUIDE FACE
G3a: FIRST CONNECTION GUIDE FACE
G3b: SECOND CONNECTION GUIDE FACE
G3c: CONTINUOUS FACE
M: ARTICLE
L1, L2: SPACING
R: GRID-LIKE TRACK (TRACK)
R1: FIRST TRACK
R2: SECOND TRACK
R3: CONNECTION TRACK
Rp: GUIDE PLATE
SYS: TRAVELING VEHICLE SYSTEM
10: MAIN BODY
20: TRAVELER
21: TRAVELING WHEEL
21a, 22a: WHEEL SHAFT
22: AUXILIARY WHEEL
30: COUPLER
40: GUIDER
41: GUIDE ROLLER
41a: ROLLER SHAFT
50: CONTROLLER
100: CEILING TRAVELING VEHICLE

## Claims

1. A traveling vehicle system (SYS) comprising:
a track (R) including a first track (R1) extending along a first direction (D1), a second track (R2) extending along a second direction (D2) different from the first direction (D1), and a connection track (R3) adjacent to the first track (R1) in the first direction (D1), adjacent to the second track (R2) in the second direction (D2), and placed with a gap (D) with respect to each of the first track (R1) and the second track (R2); and
a ceiling traveling vehicle (100) configured to travel along the track (R),
the track (R) having:
a first guide face (G1) provided along the first track (R1); and
a second guide face (G2) provided along the second track (R2), and
the ceiling traveling vehicle (100) including:
a traveling wheel (21) configured to roll on the first track (R1), on the second track (R2), and on the connection track (R3);
a main body (10) placed below the track (R);
a coupler (30) coupling a wheel shaft (21a) of the traveling wheel (21) and the main body (10) to each other and passing through the gap (D) when the traveling wheel (21) rolls on the connection track (R3);
a direction changer (34) configured to switch between a first state in which the traveling wheel (21) rolls on the first track (R1), and a second state in which the traveling wheel (21) rolls on the second track (R2), by turning the coupler (30) about a turning axis (AX2) with respect to the main body (10); and
a guider (40) provided in the coupler (30), moving along the first guide face (G1) in the first state, and moving along the second guide face (G2) in the second state,
**characterized in that**
the first guide face (G1) is a side face of the first track (R1), and
the second guide face (G2) is a side face of the second track (R2).

2. The traveling vehicle system (SYS) according to claim 1, wherein
the guider (40) is placed at a height between the wheel shaft (21a) of the traveling wheel (21) and the main body (10), and
the first guide face (G1) and the second guide face (G2) are placed at a height between the wheel shaft (21a) of the traveling wheel (21) and the main body (10).

3. The traveling vehicle system (SYS) according to any one of claims 1 and 2, wherein the guider (40) is a guide roller capable of rolling when coming into contact with the first guide face (G1) or the second guide face (G2).

4. The traveling vehicle system (SYS) according to any one of claims 1 to 3, wherein the connection track (R3) has a first connection guide face (G3a) provided at a same height and in a same direction as the first guide face (G1) and a second connection guide face (G3b) provided at a same height and in a same direction as the second guide face (G2) .

5. The traveling vehicle system (SYS) according to claim 4, wherein the connection track (R3) includes a continuous face (G3a) making the first connection guide face (G3a) and the second connection guide face (G3b) continuous with each other.

6. The traveling vehicle system (SYS) according to claim 5, wherein the continuous face (G3c) is a curved face smoothly connecting the first connection guide face (G3a) and the second connection guide face (G3b) to each other.

7. The traveling vehicle system (SYS) according to any one of claims 1 to 6, wherein the main body (10) is rectangular when viewed in an axial direction of the turning axis (AX2) of the coupler (30) and has the traveling wheel (21), the coupler (30), the direction changer (34), and the guider (40) at each of four corner parts (10a).

8. The traveling vehicle system (SYS) according to claim 7, wherein a spacing (L1) between two of the guiders (40) arranged in a traveling direction of the ceiling traveling vehicle (100) is different from a spacing (L2) between two of the gaps (D) adjacent to each other in the first direction (D1) or in the second direction (D2).

## Patentansprüche

1. Ein Bewegungsfahrzeugsystem (SYS), das folgende Merkmale aufweist:
einen Fahrweg (R) mit einem ersten Fahrweg (R1), der sich entlang einer ersten Richtung (D1) erstreckt, einem zweiten Fahrweg (R2), der sich entlang einer zweiten Richtung (D2) erstreckt, die sich von der ersten Richtung (D1) unterscheidet, und einem Verbindungsfahrweg (R3), der in der ersten Richtung (D1) benachbart zu dem ersten Fahrweg (R1) ist, in der zweiten Richtung (D2) benachbart zu dem zweiten Fahrweg (R2) ist und mit einem Zwischenraum (D) in Bezug auf sowohl den ersten Fahrweg (R1) als auch den zweiten Fahrweg (R2) platziert ist; und
ein Deckenbewegungsfahrzeug (100), das dazu ausgebildet ist, sich entlang des Fahrwegs (R) zu bewegen,
wobei der Fahrweg (R) folgende Merkmale aufweist:
eine erste Führungsfläche (G1), die entlang des ersten Fahrwegs (R1) vorgesehen ist; und
eine zweite Führungsfläche (G2), die entlang des zweiten Fahrwegs (R2) vorgesehen ist, und
das Deckenbewegungsfahrzeug (100) folgende Merkmale aufweist:
ein Bewegungsrad (21), das dazu ausgebildet ist, auf dem ersten Fahrweg (R1), auf dem zweiten Fahrweg (R2) und auf dem Verbindungsfahrweg (R3) zu rollen;
einen Hauptkörper (10), der unterhalb des Fahrwegs (R) platziert ist;
ein Kopplungselement (30), das eine Radwelle (21a) des Bewegungsrads (21) und den Hauptkörper (10) miteinander koppelt und durch den Spalt (D) verläuft, wenn das Bewegungsrad (21) auf dem Verbindungsfahrweg (R3) rollt;
ein Richtungsänderungselement (34), das dazu ausgebildet ist, zwischen einem ersten Zustand, in dem das Bewegungsrad (21) auf dem ersten Fahrweg (R1) rollt, und einem zweiten Zustand umzuschalten, in dem das Bewegungsrad (21) auf dem zweiten Fahrweg (R2) rollt, durch Drehen des Kopplungselements (30) um eine Drehachse (AX2) in Bezug auf den Hauptkörper (10); und
ein Führungselement (40), das in dem Kopplungselement (30) vorgesehen ist, sich in dem ersten Zustand entlang der ersten Führungsfläche (G1) bewegt und sich in dem zweiten Zustand entlang der zweiten Führungsfläche (G2) bewegt,
**dadurch gekennzeichnet, dass**:
die erste Führungsfläche (G1) eine Seitenfläche des ersten Fahrwegs (R1) ist und
die zweite Führungsfläche (G2) eine Seitenfläche des zweiten Fahrwegs (R2) ist.

2. Das Bewegungsfahrzeugsystem (SYS) gemäß Anspruch 1, bei dem
das Führungselement (40) an einer Höhe zwischen der Radwelle (21a) des Bewegungsrads (21) und dem Hauptkörper (10) platziert ist und
die erste Führungsfläche (G1) und die zweite Führungsfläche (G2) an einer Höhe zwischen der Radwelle (21a) des Bewegungsrads (21) und dem Hauptkörper (10) platziert sind.

3. Das Bewegungsfahrzeugsystem (SYS) gemäß einem der Ansprüche 1 und 2, bei dem das Führungselement (40) eine Führungsrolle ist, die rollen kann, wenn sie in Kontakt mit der ersten Führungsfläche (G1) oder der zweiten Führungsfläche (G2) kommt.

4. Das Bewegungsfahrzeugsystem (SYS) gemäß einem der Ansprüche 1 bis 3, bei dem der Verbindungsfahrweg (R3) eine erste Verbindungsführungsfläche (G3a), die an einer gleichen Höhe und in einer gleichen Richtung vorgesehen ist wie die erste Führungsfläche (G1), und eine zweite Verbindungsführungsfläche (G3b) aufweist, die an einer gleichen Höhe und in einer gleichen Richtung vorgesehen ist wie die zweite Führungsfläche (G2).

5. Das Bewegungsfahrzeugsystem (SYS) gemäß Anspruch 4, bei dem der Verbindungsfahrweg (R3) eine durchgehende Fläche (G3a) aufweist, die die erste Verbindungsführungsfläche (G3a) und die zweite Verbindungsführungsfläche (G3b) durchgehend zueinander macht.

6. Das Bewegungsfahrzeugsystem (SYS) gemäß Anspruch 5, bei dem die durchgehende Fläche (G3c) eine gekrümmte Fläche ist, die die erste Verbindungsführungsfläche (G3a) und die zweite Verbindungsführungsfläche (G3b) glatt miteinander verbindet.

7. Das Bewegungsfahrzeugsystem (SYS) gemäß einem der Ansprüche 1 bis 6, bei dem der Hauptkörper (10) bei Betrachtung in einer Axialrichtung der Drehachse (AX2) des Kopplungselements (30) rechtwinklig ist und das Bewegungsrad (21), das Kopplungselement (30), das Richtungsänderungselement (34) und das Führungselement (40) an jedem von vier Eckteilen (10a) aufweist.

8. Das Bewegungsfahrzeugsystem (SYS) gemäß Anspruch 7, bei dem eine Beabstandung (L1) zwischen zweien der Führungselemente (40), die in einer Bewegungsrichtung des Deckenbewegungsfahrzeugs (100) angeordnet sind, unterschiedlich von einer Beabstandung (L2) zwischen zweien der Zwischenräume (D) ist, die in der ersten Richtung (D1) oder in der zweiten Richtung (D2) benachbart zueinander sind.

## Revendications

1. Système de véhicule en déplacement (SYS) comprenant:
une piste (R) comportant une première piste (R1) s'étendant le long d'une première direction (D1), une deuxième piste (R2) s'étendant le long d'une deuxième direction (D2), différente de la première direction (D1), et une piste de connexion (R3) adjacente à la première piste (R1) dans la première direction (D1), adjacente à la deuxième piste (R2) dans la deuxième direction (D2), et placée avec un interstice (D) par rapport à chacune de la première piste (R1) et de la deuxième piste (R2); et
un véhicule en déplacement au plafond (100) configuré pour se déplacer le long de la piste (R),
la piste (R) présentant:
une première face de guidage (G1) prévue le long de la première piste (R1); et
une deuxième face de guidage (G2) prévue le long de la deuxième piste (R2), et
le véhicule en déplacement au plafond (100) comportant:
une roue de déplacement (21) configurée pour rouler sur la première piste (R1), sur la deuxième piste (R2) et sur la piste de connexion (R3);
un corps principal (10) placé au-dessous de la piste (R);
un moyen de couplage (30) couplant un arbre de roue (21a) de la roue de déplacement (21) et le corps principal (10) l'un à l'autre et passant à travers l'interstice (D) lorsque la roue de déplacement (21) roule sur la piste de connexion (R3);
un moyen de changement de direction (34) configuré pour commuter entre un premier état dans lequel la roue de déplacement (21) roule sur la première piste (R1), et un deuxième état dans lequel la roue de déplacement (21) roule sur la deuxième piste (R2), en faisant tourner le moyen de couplage (30) autour d'un axe de rotation (AX2) par rapport au corps principal (10); et
un moyen de guidage (40) prévu dans le moyen de couplage (30), se déplaçant le long de la première face de guidage (G1) dans le premier état, et se déplaçant le long de la deuxième face de guidage (G2) dans le deuxième état,
**caractérisé par le fait que**
la première face de guidage (G1) est une face latérale de la première piste (R1), et
la deuxième face de guidage (G2) est une face latérale de la deuxième piste (R2).

2. Système de véhicule en déplacement (SYS) selon la revendication 1, dans lequel
le moyen de guidage (40) est placé à une hauteur entre l'arbre de roue (21a) de la roue de déplacement (21) et le corps principal (10), et
la première face de guidage (G1) et la deuxième face de guidage (G2) sont placées à une hauteur entre l'arbre de roue (21a) de la roue de déplacement (21) et le corps principal (10).

3. Système de véhicule en déplacement (SYS) selon l'une quelconque des revendications 1 et 2, dans lequel le moyen de guidage (40) est un rouleau de guidage à même de rouler lorsqu'il entre en contact avec la première face de guidage (G1) ou avec la deuxième face de guidage (G2).

4. Système de véhicule en déplacement (SYS) selon l'une quelconque des revendications 1 à 3, dans lequel la piste de connexion (R3) présente une première face de guidage de connexion (G3a) prévue à la même hauteur et dans une même direction que la première face de guidage (G1) et une deuxième face de guidage de connexion (G3b) prévue à une même hauteur et dans une même direction que la deuxième face de guidage (G2).

5. Système de véhicule en déplacement (SYS) selon la revendication 4, dans lequel la piste de connexion (R3) comporte une face continue (G3a) rendant la première face de guidage de connexion (G3a) et la deuxième face de guidage de connexion (G3b) continues l'une avec l'autre.

6. Système de véhicule en déplacement (SYS) selon la revendication 5, dans lequel la face continue (G3c) est une face courbée connectant en douceur la première face de guidage de connexion (G3a) et la deuxième face de guidage de connexion (G3b) l'une à l'autre.

7. Système de véhicule en déplacement (SYS) selon l'une quelconque des revendications 1 à 6, dans lequel le corps principal (10) est rectangulaire, lorsque vu dans une direction axiale de l'axe de rotation (AX2) du moyen de couplage (30), et présente la roue de déplacement (21), le moyen de couplage (30), le moyen de changement de direction (34) et le moyen de guidage (40) au niveau de chacune de quatre parties de coin (1 Da).

8. Système de véhicule en déplacement (SYS) selon la revendication 7, dans lequel un espacement (L1) entre deux des moyens de guidage (40) disposés dans une direction de déplacement du véhicule en déplacement au plafond (100) est différent d'un espacement (L2) entre deux des interstices (D) adjacents l'un à l'autre dans la première direction (D1) ou dans la deuxième direction (D2).
